# EUROPEAN PATENT SPECIFICATION

(11) **EP 0 385 979 B1**
(45) Date of publication and mention of the grant of the patent: **11.08.1993**
(21) Application number: 88900618.5
(22) Date of filing: 20.10.1987
(51) Int. Cl.: H05K 7/10, H01L 21/70, H05K 3/36

(54) **HIGH-DENSITY ELECTRONIC MODULES, PROCESS AND PRODUCT**
ELEKTRONISCHE MODULE HOHER DICHTE, VERFAHREN UND ERZEUGNIS
MODULES ELECTRONIQUES A HAUTE DENSITE, PROCEDE ET PRODUIT

(43) Date of publication of application: 12.09.1990
(73) Proprietor: IRVINE SENSORS CORPORATION, Costa Mesa, CA 92626 (US)
(72) Inventor: GO, Tiong, C., El Toro, CA 92630 (US)
(74) Representative: Goddar, Heinz J., Dr.
(86) International application number: US8702746
(87) International publication number: WO8904113

(56) References cited:
- US-A- 4 617 160
- US-A- 4 630 096
- US-A- 4 706 166

## Description

### Background of the Invention

This invention relates to high-density electronic modules, which are intended to meet the apparently insatiable desire for incorporating more electronic capacity in a given space, or reducing the space required for a given amount of electronic capacity.

One of the primary uses of the present invention is to provide memory modules for use in computer apparatus. However, the same concepts may be applied to any field where high-density of electronic circuitry is desired.

To a significant extent, the background of this invention is provided by patented (or applied for) inventions assigned to the assignee of this application. Those inventions relate to the stacking and laminating of multiple chips, or substrates, each carrying integrated circuitry (IC). The stacked chips provide a module having a multiplicity of electrical leads exposed on at least one access plane of the module, the planes in which the chips extend being perpendicular to the access planes (see e.g. WO-A-8805251).

In Patent No. 4,551,629, issued November 5, 1985, the modules of stacked chips are intended to be used in conjunction with photodetectors, which are secured to one access plane of the module, and which comprise a dense array of radiation/electronic transducers.

In Patent No. 4,525,921, issued July 2, 1985, similar modules, comprising stacked, circuit-carrying chips, are intended for general use, including the computer memory components mentioned above.

The present invention is intended to solve problems involved in creating easily handled, reliable components for use as computer memories, control logic, arithmetic units, processors, and the like. It also is intended to solve problems resulting from extreme heat dissipation needs created by densely packed electronic chips, particularly where the chip material is an inefficient heat conductor.

### Summary of the Invention

In the present invention as defined in claim 1, a module of stacked IC chips is itself supported on a substrate, with its access plane resting directly on the substrate.

A metallization pattern of electrical conductors is applied to the access plane of the module, e.g., by means of vacuum and photolithography processes. A metallization pattern of electrical conductors is also applied to the face of the substrate. A layer of insulation (passivation) is provided between the access plane of the module and the adjacent face of the substrate.

Bumps of electrically-conducting bonding metal, such as indium, copper, silver or gold, are deposited on each of the interengaging surfaces, in matched positions. Then the electrical conduction systems of the two interengaging surfaces are electrically connected by bump bonding (also termed flip-chip bonding) to cause electrical bonding of matching bumps on the two surfaces. The substrate-supported module is then enclosed in a protective housing, through which extend electrical conductors which provide external connections.

In one embodiment of the invention, which uses IC chips having reasonable heat-conducting capability, the chips are shown directly secured to one another. In another embodiment of the invention, in order to provide increased heat dissipation from the stacked IC chips, and also to simplify formation of electrical interconnections, the IC chips are interleaved with layers of material which is electrically insulating, but has good thermal conduction properties.

### Brief Description of the Drawings

Figure 1 is a plan view of a standard silicon chip, which has been modified to provide edge leads along one longitudinal edge of the chip;
Figures 2A and 2B show isometrically a partially exploded view of a stack of circuit-carrying chips which are glued together to form a module, and the pattern of the metallization formed on the access plane of the module;
Figures 3B and 3B are greatly enlarged views of a small portion of the face of the access plane, and of a partial cross-section of Figure 3A, showing the relation of the IC circuitry to the metal conducting elements on the surface of the access plane;
Figures 4A, 4B and 4C show isometrically an exploded view of the stack and its conductor metallization ready to be secured to the supporting substrate, the stack and the substrate having matching conductive "bumps" ready to be bump-bonded;
Figure 5 is an isometric view of the stack of chips mounted on the substrate;
Figures 6 and 7 are plan and side views, respectively, of the structure of Figure 5;
Figures 8A, 8B and 8C show isometrically a partially exploded view of the stack-carrying substrate and the upper and lower portions of its housing;
Figure 9 is an isometric view of the encapsulated substrate/chip structure;
Figure 10 shows an electrical connection arrangement for use in providing a 512K x 9 DRAM module using 256K chips in a stack;
Figure 11 is an isometric, exploded view of an augmented heat extraction module, in which high thermal conductivity layers are interleaved between the stacked IC chips;
Figure 12 is an isometric, exploded view of the interleaved stacked chip structure of Figure 11, in which the electrical terminals on the chips are adapted to be directly connected to the electrical conductors on the stack-supporting substrate;
Figure 13 is an isometric, exploded view of the interleaved stacked chip structure of Figure 11, in which the surfaces of the interleaved layers carry electrical conductors adapted to connect the electrical terminals on the chips to the electrical conductors on the stack-supporting substrate; and
Figure 14 is an isometric close-up view of a stacked structure of the type shown in Figure 13.

### Detailed Description of Preferred Embodiment:

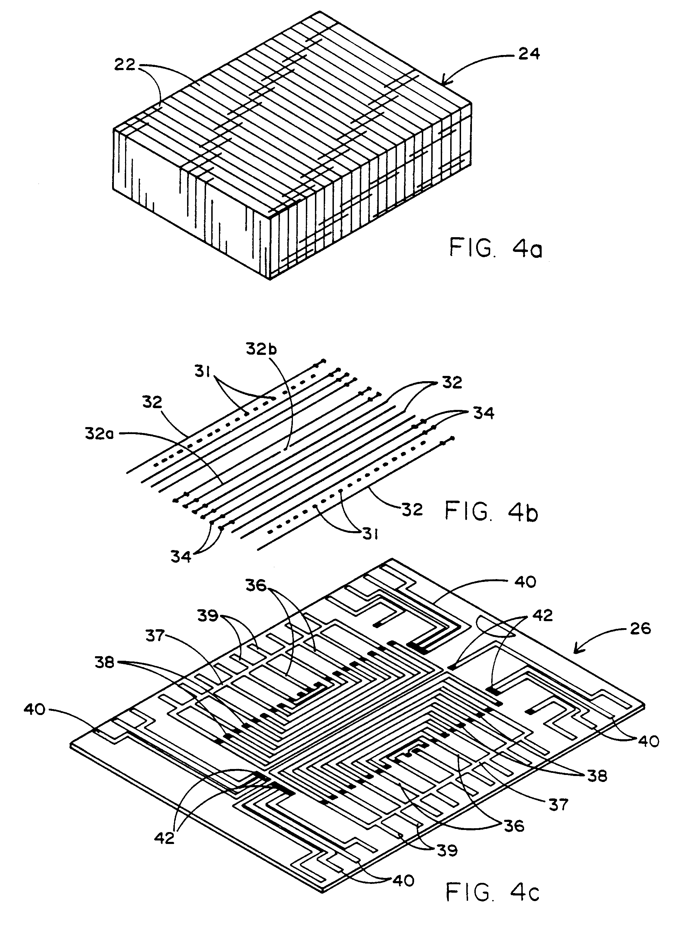

The present invention can be best explained by beginning with Figures 4A, 4B and 4C. In order to provide an electronic module having a much greater electronic density (in terms of PC board area) than prior devices, it is proposed to stack and glue together a number of chips 22, each of which carries integrated circuitry, and to mount the integrated chip stack 24 as a unit on a substrate 26. The substrate 26 supports the stacked chips and provides circuitry leading into and out of the access plane of the chip stack via conductive bumps.

The use of stacked IC chips (usually silicon) was originally developed by the assignee of this application as a means of locating extensive electronic circuitry at the focal plane of a two-dimensional detector array. The present application is directed toward an electronic package which is particularly useful in such apparatus as computers, for which it provides a module capable of containing extensive memory, control logic, processors, arithmetic units, etc. Three modules which have been the subject of extensive effort have been Read Only Memories (ROMs), Dynamic Random Access Memories (DRAMs), and Static Random Access Memories (SRAMs).

The module shown in Figure 4A is intended to be used as a DRAM, the stack having 20 IC silicon chips, 18 of which are active, and 2 of which are spares. The spares are for production redundancies, and will not be connected to the pins on the package, unless used to substitute for defective chips. The module also has blank silicon chips at each end of the stack to provide space for terminal pads. A ROM might have 8 active IC chips (or multiples of 8) in the stack. In addition to the IC chips, blank chips are needed at the ends of the stack. An SRAM module will have the same number of chips as the DRAM module.

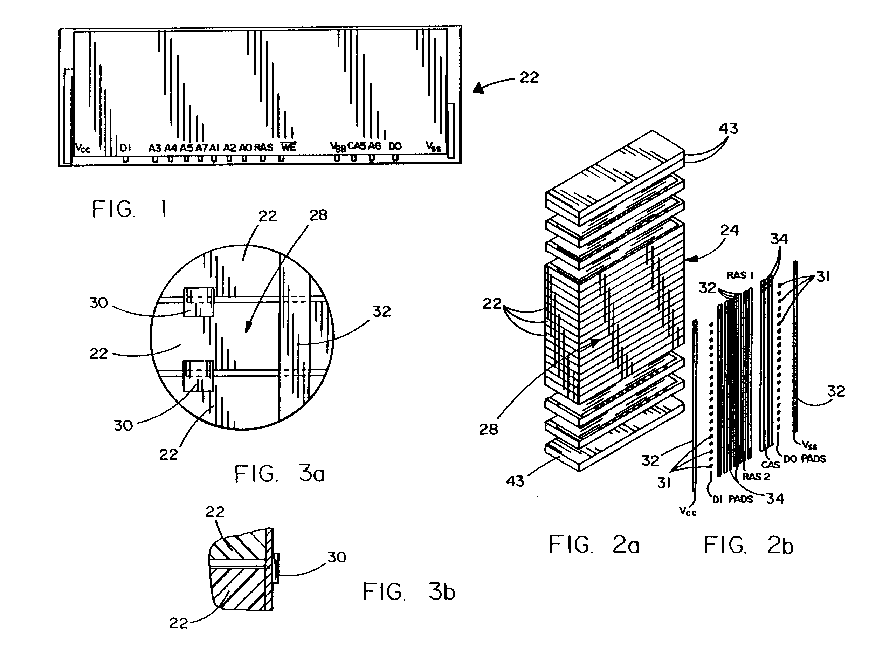

Figure 1 shows a single chip 22 intended for use in a DRAM module. Each chip can be essentially a standard memory chip except that it can be modified to provide all the electrical leads (to external circuitry) on a single edge of the chip, preferably along the long side of the rectangular area. The voltage connections Vcc, Vss and Vbb, are each bussed to provide common voltage to all chips. Each chip has its own data-in (DI) and data-out (DO) connections. The symbol RAS indicates row address select, and the symbol CAS indicates column address select, which selects the desired chip. The address terminals A0-A7 carry address input signals. The W̅E̅ terminal is the write enable connection.

A plurality of chips is stacked to provide a module, as shown in Figures 2A, 3A and 4A. All of the electrical leads (to external circuitry) on all of the chips will be on a single access plane 28 of the stacked module. This access plane will lie on the surface of supporting substrate 26, and will have suitable electrical connetions thereto, preferably accomplished by a bump-bonding process (also called "flip-chip" bonding).

The process used in stacking the chips and securing them together preferably will be similar to that covered in Application Serial No. 674,096, filed November 23, 1984, and titled "Apparatus and Method for Fabricating Modules Comprising Stacked Circuit-Carrying Layers." In that process, the chips, supplied by a vendor in the modified form, each has its thickness measured, and is placed in an appropriate storage location depending on its thickness characterization. The chip thickness data is used in a production control computer program to determine the optimum stacking order for a given module. Then the chips are cleaned and stacked, and a measured amount of epoxy is deposited between the faces of each pair of adjacent chips. The stack is placed under pressure perpendicular to the planes of the chips, in order to confine the stack to a fixed height. And then curing of the epoxy under heat is used to provide an integrated stack.

In comparing the earlier focal plane modules to those of the present application, which are intended for use in different apparatus, there is a significant trade-off. The focal plane leads, each of which connects to a separate detector, can tolerate a reasonable amount of outage, i.e. non-functioning connections (or detectors) in a given two-dimensional array. The devices provided by the present application, such as computer memory devices, cannot tolerate any connection failures. For that reason, spare chips are included in the memory modules.

On the other hand, the detector leads on a focal plane need to be very close to one another, e.g., 100 µm (four mils) center-to-center, or less. This applies both to the X-axis, which is considered to extend along the edges of the chips, and to the Y-axis, which is perpendicular to the planes of the chips. This requires the use of very thin, and therefore fragile, chips. Additionally, the position tolerances of the electrical leads are very limited.

In the present application, the center-to-center distances of the leads may be in the range of 250-500 µm (10-20 mils). This means thicker, less fragile chips may be used, and the areas of the electrical terminals (bumps) and metallic conducting strips can be substantially larger. Obviously, this simplifies significantly certain problems involved in fabrication of the modules.

After a stack 24 has been formed, it may be necessary (if the chips are semiconductors, instead of other material such as sapphire or gallium arsenide) to cover the access plane 28 with insulation (passivation), except at the points where the electrical conductors on the edges of the chips must be accessible for connection to other circuitry. This is preferably accomplished by using the process covered by Patent No. 4,525,921, referred to in the Background of the Invention.

Briefly, this process comprises: (1) grinding and lapping the access plane to expose the leads; (2) plasma etching the silicon on the access plane to remove silicon around the leads, which remain protruding from the access plane; (3) coating the access plane with a passivation layer, using a material such as polyimide; and (4) lapping again to expose the leads, while the remainder of the access plane remains insulated. If the IC layer substrate materials have little or no conductivity, e.g., gallium arsenide (GaAs), silicon-on-sapphire (SOS), or silicon on insulator (SOI), passivation would not be necessary.

The next step is applying metallization to the access plane, in order to provide electrical connections for the leads on the stacked chips. In some instances, the metallic conductor will be a pad 30 contacting only one lead on one chip, which pad may have an area of 150 µm by 150 µm (6 mils by 6 mils). In other instances, the metallic conductor will be a strip 32 contacting leads on a plurality of chips, which strip may have a width of 200 µm (8 mils). The metal pads, or conductors, may have a center-to-center spacing from one another of 250-500 µm (10-20 mils). The metallization may be applied by any desired process for obtaining printed circuitry, such as photolithography, in which a layer of photo-resist material is masked and then exposed, using ultraviolet light, in order to open windows in the photoresist, so that unwanted areas of the previously deposited metal can be etched away, leaving the desired conductor pattern.

Figures 3A and 3B show greatly enlarged close-up views of the IC leads on a silicon chip, the epoxy glue lines between adjacent stacked chips, and the metal pads 30 and strips 32 deposited on the access plane in electrical contact with the IC leads. They also show the passivation layer covering the access plane, except where the IC leads are exposed. Figure 3A is a front view of a small portion of the access plane (or active face) of the stack. Figure 3B shows a cross-section which illustrates a metal pad in engagement with the end of an IC lead, but insulated from the silicon layers.

Figures 2B and 4B show the conductor pattern on access plane 28 of integrated stack 24 after bonding bumps have been formed thereon, and prior to bonding of access plane 28 to substrate 26. Metallic bonding bumps 31 have been deposited on each of the metal pads 30. Also, metallic bonding bumps 34 have been deposited on the metallic strips 32, preferably in pairs to provide redundancy. The bump-depositing process is described below. The bump material should be very ductile, in order to avoid cracking under thermal stress. Indium is the preferred bump material, but copper, silver and gold are other possibilities.

As shown in Figure 4C, the substrate 26 also has a pattern of metallic conductors on its surface, preferably formed by the metallization process described above. The substrate has metallic strips 36 opposite stack 24, whose terminal pads have bumps 38 deposited thereon. These bumps will be subsequently bonded to the bumps 31 on the access plane. The substrate also has metallic strips 40 beyond the ends of stack 24, whose terminal pads have redundant pairs of bumps 42 thereon, which will be bonded to the bumps 34 on the access plane.

The bonding bumps 38 and 42 formed on the substrate 26 are exactly matched in location to the bonding bumps 31 and 34 formed on the access plane 28 of chip stack 24. This permits the interior (chip circuitry) and exterior (lead out and lead in) electronic circuits to be interconnected by a bump-bonding (flip-chip bonding) process. Because the interengaging bonding bumps 34 and 42 are formed on bussing line terminals, blank cover chips 43 are needed at the ends of the stack, in order to provide space for bonding the strips 32 on the stack to the strips 40 on the substrate.

In a very high volume production environment, it may not be worthwhile to "repair" a stack if one of the chips becomes defective during the stacking process. However, if reparability is desirable, redundant chips must be included in the stack. In this case the process needs to be modified as follows:
1. The metallic strips 36 on the substrate 26 originally have an interlinking conductor 37 which connects to a reduced number of outlet conductors 39.
2. After a stack has been formed, passivated, and lead cleared, metallic pads are deposited on all the leads to form electrical terminals.
3. Each layer is tested by probing the pads to determine if any of the layers (chips) is defective.
4. If a chip is defective, all the pads and leads on that chip will be removed from the access plane. A programmable YAG laser system, equipped with pattern recognition and interfaced with an automatic prober, is preferred for production applications.
5. The next step is to deposit metallic strips (bus - lines), and then form the bumps for bump-bonding.
6. After bump-bonding, the interlinking conductor 37 must be cut in such a way that the DI and DO leads from the defective chip will be isolated, while the other leads are separately connected to the conductors 39.

The link bar 37 can be made of a fusible alloy, so that the connections can be formed electrically by using an automatic-prober. There are advantages and disadvantages of fuse-blowing compared to laser cutting, but they will not be discussed here.

Before the facing access plane and stack-carrying substrate can be electrically interconnected by bump-bonding, one of the two surfaces must be covered with passivation (insulation) material, on which only the bumps are exposed. The indium or gold material which constitutes the bumps is preferably deposited after the insulation layer has been formed, or deposited on, the surface.

It is preferable to form the insulation layer on the substrate, because it is much easier to work with. The substrate is preferably formed of silicon, because it has the same thermal coefficient of expansion as the stack, and it is transparent to infrared radiation. This transparency is helpful during the bump-bonding process. Other infrared or visible transparent substrate materials might be used (e.g., a sapphire substrate will be used in silicon-on-sapphire devices).

A satisfactory insulation layer may be formed by depositing a layer of silicon dioxide (SiO₂), using, for example, a sputtering process. After the entire surface of the substrate 26 has been covered with insulation, it is necessary to make holes in the insulation to permit bonding of the indium bumps 38 and 42 to the respective strips 36 and 40. The holes should not extend beyond the width of the metallic strips, because the bump-bonding material should not be short-circuited to the silicon substrate.

Various experiments were tried unsuccessfully in efforts to deposit indium bumps in electrical contact with the metal terminals on the substrate. Use of "evaporate-through" mask techniques tended to cause a shadowing (short-circuiting) effect. And the use of a wet chemical etch, in an effort to eliminate this shadowing, caused damage to both the bumps and the electrical leads.

An apparent solution is provided by the use of "photo-resist lift-off." A 10-15 micron thick photo-resist takes the place of the evaporate-through mask. The holes are created by selectively exposing and developing the photoresist, then removing the photoresist where the bumps will be deposited. Thereafter, the indium is deposited on the exposed metal terminals and on top of the photoresist. The indium on the photoresist is removed by lifting the photoresist off of the surface, leaving indium bumps on the terminals. Each indium bump should cover substantially the same horizontal area as the area of the terminal it contacts.

The process of bump deposition on access plane 28 is similar, except that an insulation layer is not required.

In the bump bonding process, the chip stack 24 is so placed that the access plane 28 is the top surface. Then the substrate 26 is placed face down on the access plane, in order to bring the indium bumps into engagement with one another. Using an infrared microscope which "sees" through the silicon substrate, the matching bumps are brought into alignment. Then they are bonded, using heat and pressure to form welded joints.

Production will be facilitated if the material of the module-supporting substrate is light transparent to either visible or infrared radiation, so as to permit direct microscopic alignment of the bonding bumps on the access plane of the module with the bonding bumps on the adjacent face of the substrate. Indirect alignment using a reflex system can also be used, if the material is not transparent. A third method uses equipment that is available on the market, which allows alignment and planarization to be done by bringing the two sets of bumps in close proximity to each other, and then viewing them directly from the edges of the substrate module - thus permitting the substrate to be non-transparent.

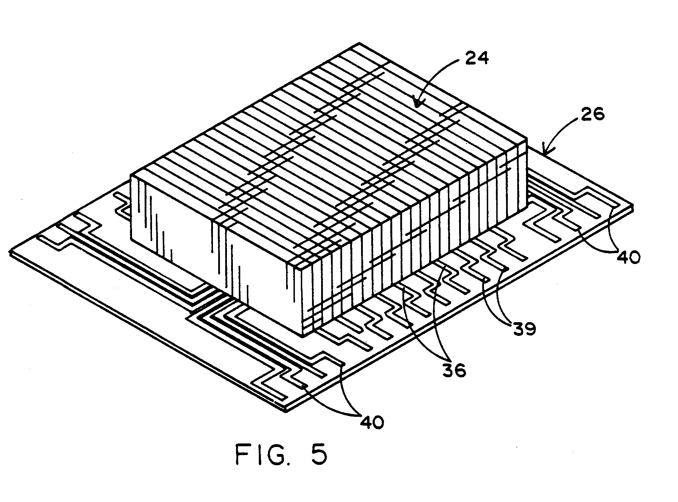

Figures 5-7 show the complete stack/substrate subassembly. The metallic strips on the substrate extend to its opposite long-dimension edges, in order to be readily connected to external circuitry by wire bonding.

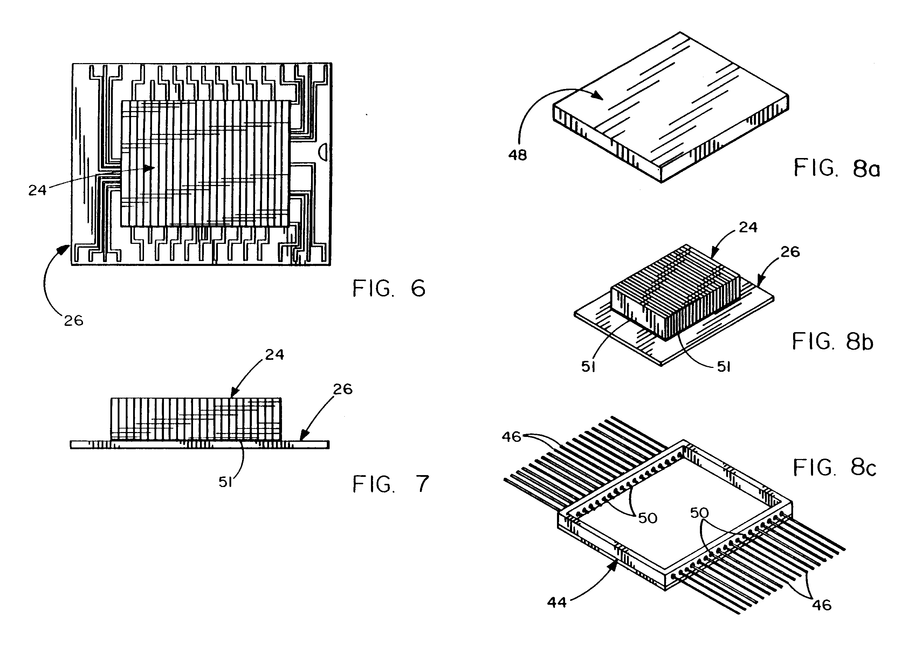

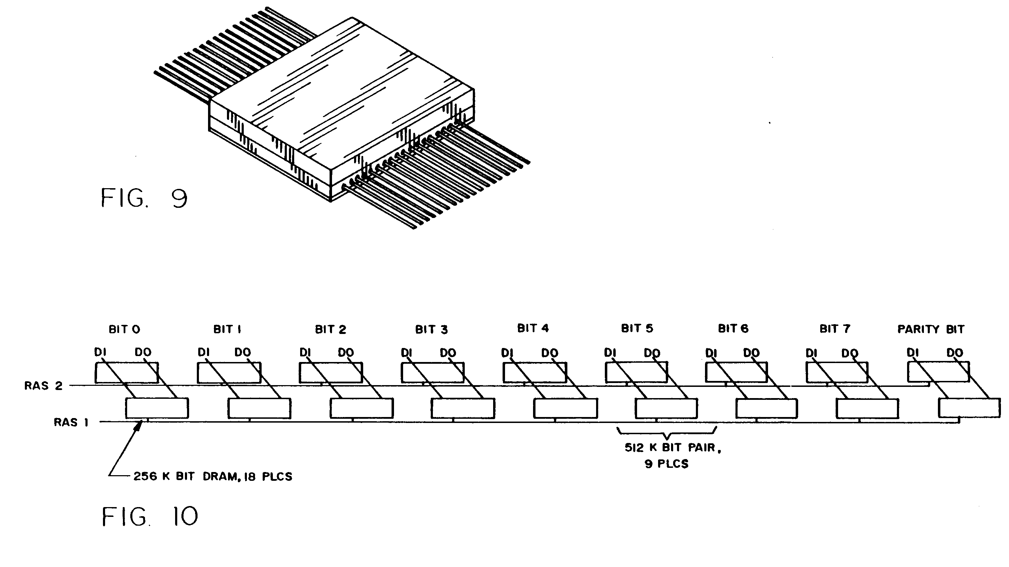

Figures 8A, 8B and 8C show the container, or housing, in which the chips and substrate are placed. Figure 8C shows the lower portion 44 of the container (a flat-pack), from which extend electrical leads 46, the inner ends of which are wire bonded to the metal strips on the substrate (not shown). The package is completed by welding an upper portion, or cover 48 (Figure 8A) to the lower portion 44, thereby enclosing the stack/substrate sub-assembly. Preferably the container parts 44 and 48 are metal, in order to permit heat dissipation. This necessitates having insulation rings 50 between each electrical lead 46 and the container walls. Figure 9 shows the complete encapsulated package. Beryllia (BeO) would be preferred as the container material when very high power dissipation is required; but its high cost must be taken into consideration.

Power dissipation is a limiting factor in circuit density. Therefore, heat transfer from the IC chips is a significant consideration. In order to permit heat flow from the IC chips to the substrate 26, it is important, after bump bonding, to fill the gap between the chip stack and the substrate with a thermally-conductive (but electrically non-conductive) material 51. This is accomplished with a suitable epoxy, which provides a strong bond as well as heat dissipation.

Figure 10, considered in conjunction with Figures 4B and 4C, provides a particular DRAM circuit, which is designed to use 18 chips, each having 256K memory capability, in serial pairs, thereby providing a 512K x 8 DRAM module (with a parity bit). Each bit, from Bit 0 through Bit 7 (and the parity bit), combines two chips, by interconnecting their data-in and data-out lines. Row address lines RAS1 and RAS2 each connect to half of the chips.

Providing these nine pairings is not a trivial problem. The normal assumption would be that adjacent chips should be paired. But such pairing would create an almost insurmountable conductor cross-over problem on the substrate.

One solution is illustrated in Figures 4B and 4C. Each line 36 on substrate 26 is connected to two chips. The lines 36 on one side of the substrate connect to the data-in pads on the chips, and the lines 36 on the other side of the substrate connect to the data-out pads on the chips. A first line 36 interconnects the two end chips. A second line 36 interconnects the two chips closest to the respective end chips. A third line 36 interconnects the next two chips closest to the respective end chips; and so on, until the last two interconnected chips are adjacent to one another.

On the access plane of the stacked chips, one of the strips 32, which is designated 32A, has a gap at 32B because the group of chips on one side of the gap have a common row address line, and the group of chips on the other side of the gap have a common row address line, which is not connected to the first group. This simple busing arrangement of the row address lines would not be possible if each chip were not paired with a chip on the other side of the gap, i.e., a chip in the other group.

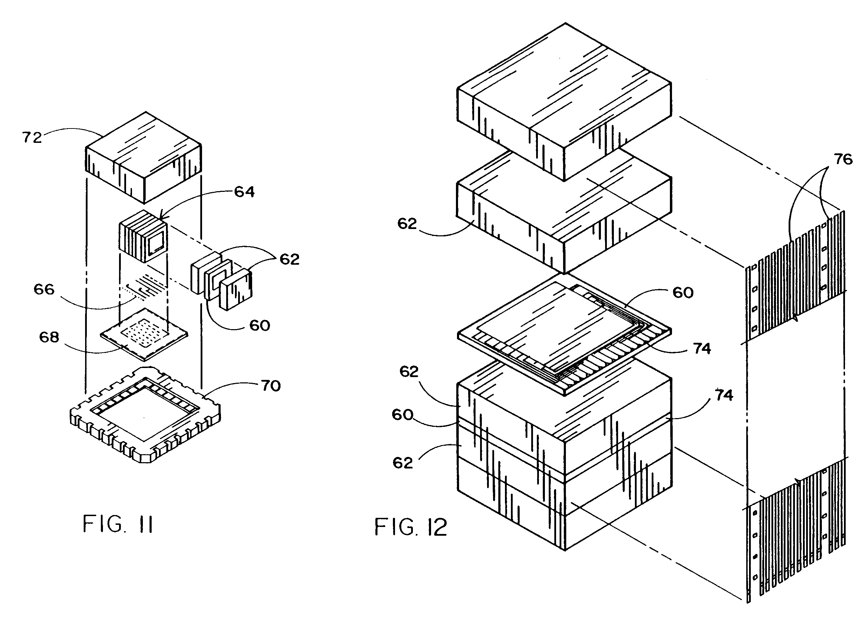

Figure 11-14 show another embodiment of the invention, which provides an augmented heat extraction structure, by including in the stack of IC chips interleaved layers of material having high thermal conductivity. The additional layers serve the primary function of heat conduction, and they may also be useful in providing extra real estate for the support of electrical conductors.

Heat dissipation is not usually a serious problem when silicon IC chips are stacked. However, stacks of gallium arsenide (GaAs) IC chips may be used, where much higher operating speed is desired Since GaAs is a very poor heat conductor, and since it operates at a higher power level than silicon, heat cannot be effectively extracted from a stack of GaAs chips, unless a different stack arrangement is provided.

The present invention uses interleaved layers, which are made of effective heat-conducting material, and which are included in the stack, along with the IC chips.

Figure 11 shows the components of a stacked chip package having interleaved heat-conducting layers. A plurality of IC chips 60 are alternated in the stack with a plurality of heat-conductive layers 62. The chips may be composed of silicon, gallium arsenide, or other suitable material. However, as previously stated, need for the interleaved layers 62 is much greater when GaAs (or sapphire substrate) chips are used, because such chips have both high power requirements and low thermal conductivity.

The preferred material for the heat-conducting layers is beryllium oxide (BeO). This material is both an electrical insulator and an excellent heat conductor.

Where both the chips (e.g. gallium arsenide) and the interleaves (e.g. beryllium oxide) are electrical non-conductors, a processing simplification is realized. There is no need for the etching-passivation-lapping steps on the stack, as would be required on a silicon stack (see Pat. 4,525,921).

The IC chips 60 and interleaved layers 62 may not always be alternated. In some situations, a pair of IC chips might provide adjacent layers. In the figure, the thickness of the layers 62 is somewhat exaggerated in proportion to the thickness of the chips 60. In a practical combination each chip 60 might have a thickness of 200 µm (.008 inch), and each layer 62 might have a thickness of 500 µm (.020 inch). In addition to the interleaved layers, two extra heat-conducting layers are included at one end of the stack, and one such layer at the other end. These added layers provide boundary areas at the stack ends to eliminate thin film processing difficulties that might arise from ending the thin film leads at the edge of the stack. The added end layers also provide area for locating the bus line bump bonds, without interference with the individual signal lines connected to each access plane lead.

After a laminated stack 64 has been formed with glue lines between adjacent layers, the stack has interconnect wiring 66 printed on its interconnect (or access) surface; and that surface is supported on, and secured to, a stack-carrying substrate 68. The electrical interconnections between the interconnect plane of the stacked chips and the stack-carrying substrate may be formed by the bump-bonding process previously described. After bump-bonding the bumps on the stack to the bumps on the stack-carrying substrate 68, it is desirable to fill the remaining space between the stack and its supporting substrate with an electrically insulating, thermally conducting epoxy material. This epoxy material provides an additional heat flow path, as well as a strong bond between the stack and the substrate 68.

The stack-carrying substrate 68 may be made of beryllium oxide (BeO) to provide maximum heat conduction. However, BeO is not transparent to infrared; and its use makes aligning of the bumps more difficult. For this reason, silicon may be preferred in some situations as the material for the stack-carrying substrate 68.

Subsequently, the stack-carrying substrate can be mounted on a carrier 70, and enclosed by securing a cover 72 to carrier 70. Preferably, the cover 72 is hermetically sealed to carrier 70 by glass or reflow solder.

Figure 12 shows part of a stack, in which the interleaves 62 function solely as heat transferring members. The electrical leads on each IC chip 60 are brought to the interconnect plane edge 74 of the chip. Metal strips 76 are formed by thin film (or thick film) techniques on the interconnect plane; and suitable electrical connections from the stack-carrying substrate are directly in contact (through terminals and bumps) with leads at the edges of the chips.

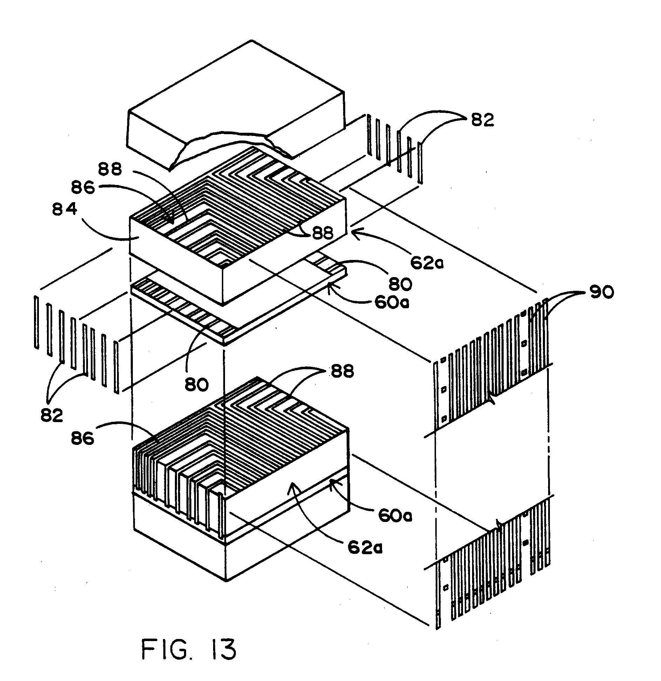

Figure 13 shows a stacked structure in which the interleaved layers 62a perform the additional function of providing surfaces on which electrical conductors are formed, which conductors extend from terminals on the IC chips 60a to the interconnect plane of the stack. It is the terminals formed at the ends of these conductors which are in electrical contact with terminals formed on the stack-carrying substrate (via bonded bumps).

In the structure of Figure 13, it is assumed that electrical leads 80 extend to two sides (edges) of each IC chip 60a. Metal strips 82, which are formed on two opposite sides 84 of each layer 62a make contact with the individual leads 80 in the chips 60a, and carry their respective signals to the flat surface 86 on top of layer 62a. Metal strips 88 (L-shaped) on surface 86 interconnect the respective side strips 82 with leads at the interconnect plane of the stack. These leads are in contact with metal strips 90 formed on the interconnect plane; and their electrical contact with conductors on the stack-supporting substrate is accomplished in the manner described above.

This system of electrical conductors has the capability of re-routing the leads at the edges of the IC chips, and permits a larger number of leads to reach the interconnect plane. In some instances this permits use of IC chips without vendor modification of the normal chip leads. Standard IC chips have leads at two or more sides. Therefore, non-standard chips are required in the modules where all leads on the chips must extend directly to the access (interconnect) plane.

The extensive conductor wiring layouts shown in Figure 13 require additional, highly precise, process steps. The side conductors 82 are metallization strips which extend across the contacting edges of the leads 80 on the IC chips, and across the contacting edges of the leads at the ends of conductor strips 88 on surface 86. This provides T-shaped connections, which are intended to insure functional electrical contact of the side conductors 82.

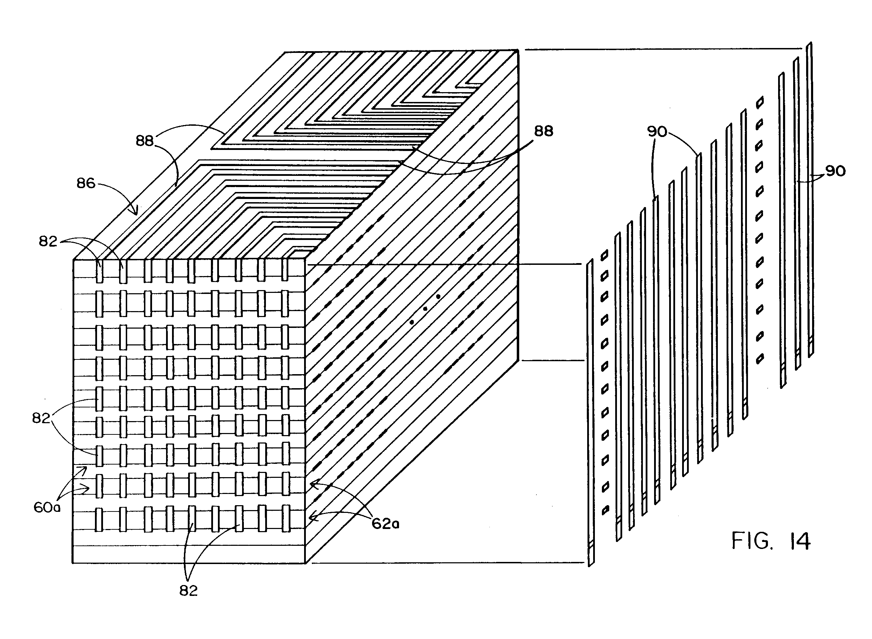

Figure 14 is an enlarged view of the stack of Figure 13, and shows more clearly the layout of the side conductors 82, and the top conductors 88 which bring the IC leads from opposite edges of each IC chip to a single edge of the interleaf, at the access plane.

Re-routing of the leads from the IC chips may also be necessary where a stack of chips includes different types of ICs, i.e., chips which perform different functions. In such a situation, two re-routing methods are possible.

The first is to print connecting metallic lines on the back side of each IC chip to re-route the leads to another plane. This requires front-to-back alignment of the wafer (from which the chip was diced) -- a difficult and expensive process. Also, unless all the chips of that particular type used on the same stack need the same re-routing requirement, having the same metal lead patterns on all of them can cause problems in the metallization of the access planes. Another problem is cross-talk between the re-routing lines (on the back of one chip) and the circuitry on the adjacent chip below it.

The second, and preferred, method is to use interleaves as conductor substrates, as described above. Forming of conductors on an interleaf is much easier than forming conductors on the back of a chip. It does not require a front-to-back alignment process. It avoids cross talk due to proximity of the conductors. Additionally, it is very versatile. Different patterns can be made for a given type of chip which connect it to other chips, without major logistic and cost considerations.

The use of the high thermal conductivity interleaves in a stack of IC chips allows generic packaging technology to accommodate advances in state-of-the-art memory chip density, speed of operation, and increased power dissipation demands, as alternate chip materials with lower thermal conductivity or increased thermal loads are developed. And also, where remetallization of the IC chip leads is impractical, or where different types of IC chips are stacked together, the interleave layers provide a practical method for rerouting of electrical conductors.

From the foregoing description, it will be apparent that the process and product disclosed in this application will provide the significant functional benefits summarized in the introductory portion of the specification.

The following claims are intended not only to cover the specific embodiments disclosed, but also to cover the inventive concepts explained herein with the maximum breadth and comprehensiveness permitted by the prior art.

## Claims

1. A method for fabricating a package containing high density electronic circuitry, comprising:
providing a plurality of integrated circuit chips (22;60,60a), each having a multiplicity of closely-spaced electrical leads at one or more edges thereof;
stacking and bonding the integrated circuit chips in a structure having an access plane (28), on which plane there is a two-dimensional array of said closely-spaced electrical leads;
forming on the access plane, in direct or indirect electrical contact with the chip leads, a plurality of conductive lines (32) and a plurality of conductive terminals (30);
providing a stack-carrying substrate (26) adapted to support the stacked chips and having formed thereon a plurality of conductive lines (36,37,39,40) and a plurality of conductive terminals;
the conductive terminals on the access plane being located in precise matched relationship with the conductive terminals on the stack-carrying substrate;
covering either the substrate or the access plane with a layer of insulation having openings therethrough matched to the conductive terminals on the substrate and the access plane;
depositing electrically conducting bonding bumps (31,34,38,42) on the conductive terminals of both the access plane and the substrate;
aligning the bonding bumps (38,42) on the substrate with those (31,34) on the access plane; and
using heat and/or pressure to bond the aligned bonding bumps together, thereby providing a plurality of parallel electrical connections between the access plane and the substrate.

2. The method of Claim 1 which also comprises:
interspersing in the stack of integrated circuit chips (60,60a) a plurality of interleaved layers (62,62a) formed of material having high thermal conductivity to extract heat from the stack.

3. The method of Claim 2 in which the material of the interleaved layers is beryllium oxide.

4. The method of Claim 2 which also comprises:
forming on at least some of the interleaved layers (62a) electrical conductors (82,88) which interconnect the leads (80) on the integrated circuit chips (60a) to the conductive lines (90) on the access plane of the stacked structure.

5. The method of Claim 1 in which the leads on the integrated circuit chips connect directly to the access plane.

6. The method of Claim 1 which also comprises:
including in the conductive lines on the stack-carrying substrate parallel conductors (36) electrically connected to each chip, a conductor (37) interlinking those conductors, and a reduced number of parallel conductors (39) leading from the interlinking conductor toward external circuitry;
determining whether any chip in the stacked structure is defective; and
removing portions of the interlinking conductor in order to isolate the defective chip from external circuitry.

7. The method of claim 1 wherein the substrate is transparent to certain radiation wavelengths, and alignment of the bonding bumps on the access plane with those on the substrate is accomplished by directing such radiation through the surface of the substrate opposite its circuit-carrying surface.

8. The method of claim 1 wherein the space remaining between the access plane and the substrate after the bump bonding process is filled with a thermally-conductive, electrically-non-conductive adhesive (51).

9. A high-density electronic module comprising:
a plurality of integrated circuit chips (22), each having electrical leads extending to at least one side of the chip;
the chips being secured together to provide an integrated stack (24), in which the electrical leads on the chips are connected directly or indirectly to a single two-dimensional access plane (28);
a stack-supporting substrate (26) which has electrical conductors thereon, and which is adapted to provide a support for the stacked chips;
a first group of bonding bumps (31,34) deposited on the access plane of the stack;
a second group of bonding bumps (38,42) deposited on the conductors of the stack-supporting substrate;
insulation on the surface of either the access plane of the stack or the stack-supporting substrate, which covers said surface except for the bonding bumps;
each bonding bump on the stack being bonded to a bonding bump on the substrate, in order to provide parallel electrical contacts between the stack and the substrate at selected conductive terminals thereof.

10. The module of claim 9 which also comprises:
a layer of thermally-conducting adhesive material (51) between the stack and the substrate except where the bonding bumps are in interengagement.

11. The module of claim 9 which also comprises:
a plurality of layers (62,62a) which are interleaved in the stack with the integrated circuit chips (60), and which are formed of material having high thermal conductivity.

12. The module of claim 11 in which the material of the interleaved layers is beryllium oxide.

13. The module of claim 11 which also comprises:
electrical conductors (82,88) formed on at least some of the interleaved layers (62a) as electrical interconnections between the electrical leads (80) on the integrated circuit chips (60a) and the access plane of the stack.

14. The module of claim 9 in which the electrical leads on the integrated circuit chips are on the access plane of the stack.

## Patentansprüche

1. Verfahren zum Herstellen einer eine elektronische Schaltung hoher Dichte enthaltenden Baueinheit, das die folgenden Schritte umfaßt:
Bereitstellen einer Vielzahl von integrierten Schaltungschips (22; 60, 60a), wobei jeder eine Mannigfaltigkeit von dichtstehenden elektrischen Leitungen an einer oder mehrerer seiner Kanten aufweist;
Aufstapeln und Verbinden der integrierten Schaltungschips zu einem Aufbau mit einer Zugangsebene (28), auf welcher ein zweidimensionales Feld von besagten dichtstehenden elektrischen Leitungen vorhanden ist;
Bilden einer Vielzahl von leitenden Anschlüssen (32) und einer Vielzahl von leitenden Kontakten (30) auf der Zugangsebene, in direktem oder indirektem elektrischen Kontakt mit den Chipleitungen;
Bereitstellen eines stapeltragenden Substrats (26), das die gestapelten Chips trägt und eine Vielzahl von darauf gebildeten leitenden Anschlüssen (36, 37, 39, 40) und eine Vielzahl von leitenden Kontakten aufweist;
wobei die leitenden Kontakte auf der Zugangsebene in genau an die leitenden Kontakte auf dem stapeltragenden Substrat angepaßter Beziehung angeordnet sind;
Abdecken entweder des Substrats oder der Zugangsebene mit einer Isolationsschicht, die durch sie hindurchgehende, an die leitenden Kontakte auf dem Substrat und der Zugangsebene angepaßte Öffnungen aufweist;
Setzen von elektrisch leitenden Bindungsvorsprüngen (31, 34, 38, 42) auf die leitenden Kontakte sowohl der Zugangsebene als auch des Substrats;
Ausrichten der Bindungsvorsprünge (38, 42) auf dem Substrat zu denen (31, 34) auf der Zugangsebene; und
Benutzen von Wärme und/oder Druck, um die ausgerichteten Bindungsvorsprünge miteinander zu verbinden, wodurch eine Vielzahl von parallelen elektrischen Verbindungen zwischen der Zugangsebene und dem Substrat geschaffen wird.

2. Verfahren nach Anspruch 1, gekennzeichnet durch:
Einstreuen einer Vielzahl von Zwischenschichten (62, 62a) in den Stapel der integrierten Schaltungschips (60, 60a), die aus einem Material mit hoher Wärmeleitfähigkeit gebildet sind, um dem Stapel Wärme zu entziehen.

3. Verfahren nach Anspruch 2, dadurch gekennzeichnet, daß das Material der Zwischenschichten Berylliumoxid ist.

4. Verfahren nach Anspruch 2, gekennzeichnet durch:
Bilden elektrischer Leiter (82, 88) auf zumindest einer der Zwischenschichten (62a), die die Leitungen (80) auf den integrierten Schaltungschips (62a) mit den leitenden Anschlüssen (90) auf der Zugangsebene des gestapelten Aufbaus verbinden.

5. Verfahren nach Anspruch 1, dadurch gekennzeichnet, daß die Leitungen auf den integrierten Schaltungschips direkt mit der Zugangsebene verbunden sind.

6. Verfahren nach Anspruch 1, gekennzeichnet durch:
Enthalten von parallelen Leitern (36) in den leitenden Anschlüssen auf dem stapeltragenden Substrat, die elektrisch mit jedem Chip verbunden sind, wobei ein Leiter (37) diese Leiter verkettet, und eine reduzierte Anzahl von parallelen Leitern (39) von dem verkettenden Leiter zu einer externen Schaltung führt;
Bestimmen, ob irgendein Chip in dem gestapelten Aufbau defekt ist; und
Entfernen von Bereichen des verkettenden Leiters, um den defekten Chip von der externen Schaltung zu isolieren.

7. Verfahren nach Anspruch 1, dadurch gekennzeichnet, daß das Substrat für bestimmte Bestrahlungswellenlängen transparent ist, und daß die Ausrichtung der Bindungsvorsprünge auf der Zugangsebene zu denen auf dem Substrat durch Lenken solcher Bestrahlung durch die Oberfläche des Substrats, die gegenüber ihrer schaltungstragenden Oberfläche liegt, bewerkstelligt wird.

8. Verfahren nach Anspruch 1, dadurch gekennzeichnet, daß der zwischen der Zugangsebene und dem Substrat verbleibende Abstand nach dem Vorsprungsbindungsprozeß mit einem wärmeleitenden, nicht elektrisch leitenden Klebstoff (51) gefüllt wird.

9. Elektronisches Modul hoher Dichte, das folgendes umfaßt:
eine Vielzahl von integrierten Schaltungschips (22), wobei jeder elektrische Leitungen aufweist, die sich zumindest zu einer Seite des Chips erstrecken;
wobei die Chips aneinander befestigt sind, um einen integrierten Stapel (24) zu liefern, in welchem die elektrischen Leitungen auf den Chips direkt oder indirekt mit einer zweidimensionalen Zugangsebene (28) verbunden sind;
ein stapeltragendes Substrat (26), welches elektrische Leiter aufweist und einen Träger für die gestapelten Chips bereitstellt;
eine erste Gruppe von Bindungsvorsprüngen (31, 34), die auf der Zugangsebene des Stapels aufgesetzt sind;
eine zweite Gruppe von Bindungsvorsprüngen (38, 42), die auf den Leitern des stapeltragenden Substrats aufgesetzt sind; einen Isolator auf der Oberfläche entweder der Zugangsebene des Stapels oder des stapeltragenden Substrats, der besagte Oberfläche außer an den Bindungsvorsprüngen überdeckt;
wobei jeder Bindungsvorsprung auf dem Stapel mit einem Bindungsvorsprung auf dem Substrat verbunden ist, um parallele elektrische Kontakte zwischen dem Stapel und dem Substrat an ausgewählten leitenden Kontakten derselben zu liefern.

10. Modul nach Anspruch 9, gekennzeichnet durch:
eine Lage eines wärmeleitenden Klebstoffmaterials (51) zwischen dem Stapel und dem Substrat, außer an den Verbindungsstellen der Bindungsvorsprünge.

11. Modul nach Anspruch 9, gekennzeichnet durch:
eine Vielzahl von Zwischenschichten (62, 62a) in dem Stapel mit den integrierten Schaltungschips (60), die aus Material mit hoher Wärmeleitfähigkeit gebildet sind.

12. Modul nach Anspruch 11, dadurch gekennzeichnet, daß das Material der Zwischenschichten Berylliumoxid ist.

13. Modul nach Anspruch 11 gekennzeichnet durch:
elektrische Leiter (82, 88), die zumindest auf einigen der Zwischenschichten (62a) als elektrische Verbindungen zwischen den elektrischen Leitungen (80) auf den integrierten Schaltungschips (60a) und der Zugangsebene des Stapels gebildet sind.

14. Modul nach Anspruch 9, dadurch gekennzeichnet, daß die elektrischen Leitungen auf den integrierten Schaltungschips auf der Zugangsebene des Stapels sind.

## Revendications

1. Procédé de fabrication d'un module contenant des circuits électroniques à haute densité, selon lequel :
- on prend un certain nombre de puces de circuit intégré (22; 60, 60a) ayant chacune, sur un ou plusieurs bords, un grand nombre de fils électriques très rapprochés,
- on empile et on relie les puces de circuit intégré en une structure ayant un plan d'accès (28) sur lequel il y a un réseau bidimensionnel desdits fils électriques très rapprochés,
- on forme sur le plan d'accès, en contact électrique direct ou indirect avec les fils des puces, un certain nombre de pistes conductrices (32) et un certain nombre de bornes conductrices (30),
- on prend un substrat de support de pile (26) fait pour supporter les puces empilées et sur lequel sont formées un certain nombre de pistes conductrices (36, 37, 39, 40) et un certain nombre de bornes conductrices,
- les bornes conductrices du plan d'accès étant placées dans des positions correspondant avec précision à celles des bornes conductrices du substrat de support de pile,
- on couvre soit le substrat, soit le plan d'accès, d'une couche d'isolant traversée par des ouvertures correspondant aux bornes conductrices du substrat et du plan d'accès,
- on dépose des bossages de liaison conducteurs de l'électricité (31, 34, 38, 42) sur les bornes conductrices du plan d'accès et celles du substrat,
- on aligne les bossages de liaison (38, 42) du substrat avec ceux (31, 34) du plan d'accès, et
- on utilise la chaleur et/ou la pression pour relier les bossages de liaison alignés et par là créer un certain nombre de connexions électriques parallèles entre le plan d'accès et le substrat.

2. Procédé selon la revendication 1, dans lequel aussi on intercale dans la pile de puces de circuit intégré (60, 60a) un certain nombre de couches (62, 62a) faites d'une matière ayant une haute conductivité thermique, pour extraire la chaleur de la pile.

3. Procédé selon la revendication 2, dans lequel les couches intercalées sont en oxyde de béryllium.

4. Procédé selon la revendication 2, dans lequel aussi on forme sur au moins quelques-unes des couches intercalées (62a) de conducteurs électriques (82, 88) qui relient les fils (80) des puces de circuit intégré (60a) aux pistes conductrices (90) du plan d'accès de la structure empilée.

5. Procédé selon la revendication 1, dans lequel les fils des puces de circuit intégré sont connectées directement au plan d'accès.

6. Procédé selon la revendication 1, dans lequel, aussi
- on applique sur les pistes conductrices du substrat de support de pile de conducteurs parallèles (36) reliés électriquement à chaque puce, un conducteur (37) reliant ces conducteurs, et un nombre réduit de conducteurs parallèles (39) allant du conducteur de liaison vers les circuits extérieurs,
- on vérifie le bon état des puces de la structure empilée et
- on enlève des parties du conducteur de liaison pour isoler, des circuits extérieurs, les puces défectueuses.

7. Procédé selon la revendication 1, dans lequel le substrat est transparent à certaines longueurs d'onde de rayonnement, et l'alignement des bossages de liaison du plan d'accès avec ceux du substrat est accompli par envoi d'un tel rayonnement à travers la face du substrat opposée à sa face supportant les circuits.

8. Procédé selon la revendication 1, dans lequel l'espace restant entre le plan d'accès et le substrat après l'opération de liaison des bossages est rempli d'un adhésif thermiquement conducteur et non conducteur de l'électricité (51).

9. Module électronique à haute densité comprenant :
- un certain nombre de puces de circuit intégré (22) ayant chacune des fils électriques s'étendant jusqu'à au moins un côté de la puce,
- ces puces étant fixées les unes aux autres pour créer une pile intégrée (24) dans laquelle les fils électriques des puces sont connectés directement ou indirectement à un plan d'accès bidimensionnel unique (28),
- un substrat de support de pile (26) qui porte des conducteurs électriques et est fait pour fournir un support aux puces empilées,
- un premier groupe de bossages de liaison (31, 34) déposés sur le plan d'accès de la pile,
- un second groupe de bossages de liaison (38, 42) déposés sur les conducteurs du substrat de support de pile,
- un isolant sur la surface soit du plan d'accès de la pile, soit du substrat de support de pile, qui couvre cette surface à l'exception des bossages de liaison,
- chaque bossage de liaison de la pipe étant uni à un bossage de liaison du substrat pour créer des contacts électriques parallèles entre la pile et le substrat à des bornes conductrices choisies de ceux-ci.

10. Module selon la revendication 9, qui comprend aussi une couche de matière adhésive thermiquement conductrice (51) entre la pile et le substrat excepté aux endroits où les bossages de liaison sont en prise mutuelle.

11. Module selon la revendication 9, qui comprend aussi un certain nombre de couches (65, 62a) qui sont intercalées dans la pipe entre les puces de circuit intégré (60) et sont faites d'une matière ayant une haute conductivité thermique.

12. Module selon la revendication 11, dans lequel les couches intercalées sont en oxyde de béryllium.

13. Module selon la revendication 11, qui comprend aussi des conducteurs électriques (82, 88) formés sur au moins quelques-unes des couches intercalées (62a) comme liaisons électriques entre les fils électriques (80) des puces de circuit intégré (60a) et le plan d'accès de la pile.

14. Module selon la revendication 9, dans lequel les fils électriques dos puces de circuit intégré sont sur le plan d'accès de la pile.
